(19) Europäisches Patentamt
European Patent Office
Office européen des brevets

(11) **EP 4 074 792 B1**

(12) **EUROPEAN PATENT SPECIFICATION**

(45) Date of publication and mention of the grant of the patent:
**02.04.2025 Bulletin 2025/14**

(21) Application number: **20900201.3**

(22) Date of filing: **07.12.2020**

(51) International Patent Classification (IPC):
***C09G 1/02*** *(2006.01)* ***C09K 3/14*** *(2006.01)*
***B24B 37/00*** *(2012.01)* ***H01L 21/304*** *(2006.01)*
***H01L 21/02*** *(2006.01)*

(52) Cooperative Patent Classification (CPC):
**C09G 1/02; H01L 21/02024**

(86) International application number:
**PCT/JP2020/045532**

(87) International publication number:
**WO 2021/117689 (17.06.2021 Gazette 2021/24)**

(54) **CHEMICAL-MECHANICAL POLISHING COMPOSITION AND CHEMICAL-MECHANICAL POLISHING METHOD IN WHICH SAME IS USED**

CHEMISCH-MECHANISCHE POLIERZUSAMMENSETZUNG UND DEREN VERWENDUNG IN EINEM CHEMISCH-MECHANISCHEN POLIERVERFAHREN

COMPOSITION DE POLISSAGE CHIMICO-MÉCANIQUE ET PROCÉDÉ DE POLISSAGE CHIMICO-MÉCANIQUE FAISANT APPEL À CELLE-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.12.2019 JP 2019225212**

(43) Date of publication of application:
**19.10.2022 Bulletin 2022/42**

(73) Proprietor: **Entegris, Inc.**
**Billerica, MA 01821 (US)**

(72) Inventors:
- **KITAMURA, Hiroshi**
  **Tsu-shi, Mie 514-2213 (JP)**
- **NAMIKI, Akihisa**
  **Tsu-shi, Mie 514-2213 (JP)**
- **MASUDA, Tsuyoshi**
  **Tsu-shi, Mie 514-2213 (JP)**
- **MATSUMURA, Yoshiyuki**
  **Tsu-shi, Mie 514-2213 (JP)**

(74) Representative: **Barker Brettell LLP**
**100 Hagley Road**
**Edgbaston**
**Birmingham B16 8QQ (GB)**

(56) References cited:
**EP-A1- 3 159 915** **EP-A1- 3 425 016**
**WO-A1-2012/102144** **WO-A1-2018/043504**
**JP-A- 2014 151 424** **JP-A- 2015 174 938**
**JP-A- 2017 128 638** **JP-A- 2017 155 198**
**JP-A- 2019 127 585** **JP-A- 2020 013 824**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

FIELD

The present invention relates to a chemical-mechanical polishing composition and a chemical-mechanical polishing method using the same.

BACKGROUND

Substrates such as silicon wafers used in the production of semiconductor devices have strict surface quality requirements, and in order to ensure high surface quality, conventionally, a chemical-mechanical polishing (CMP) technology has been used. In general, the CMP of a substrate such as a silicon wafer comprises a plurality of steps, and includes, for example, a pre-polishing step and a finish polishing step. In the finish polishing step after the pre-polishing step, conventionally, by using a polishing composition (also called CMP slurry) having a weaker polishing power than in the pre-polishing step, the surface quality of the substrate, for example, surface quality such as surface defects and haze characteristics, is improved.

Surface defect inspection devices are generally used to manage surface defects of substrates such as silicon wafers. The defects detected by a surface defect inspection device include foreign matter and residue on a silicon wafer which could not be removed in the polishing step or a subsequent rinsing step. As such a surface defect inspection device, devices which irradiate the substrate surface with light such as laser light, and which detect reflected light or scattered light generated by the substrate surface to detect the presence or absence of defects on the substrate surface are generally known.

When the substrate surface is irradiated with such strong light, clouding may be seen due to diffused reflection as a result of the roughness of the substrate surface. This clouding is referred to as haze, and since haze has a close relationship with the surface roughness of the substrate, haze can be used as an indicator of surface roughness. In recent years, though surface defects can be observed on a nano-level due to the rapid progress of surface defect inspection devices, when haze is present on a substrate surface, the diffusely reflected light caused by the haze becomes background noise, whereby defect detection by the surface defect inspection device may be hindered.

In order to reduce the surface defects and haze described above, in particular, management of the chemical-mechanical polishing composition used in the finish polishing step, and more specifically, management of the CMP slurry which is actually supplied to the substrate at the time of use (at the time of polishing) is important. In the chemical-mechanical polishing composition for the CMP of a substrate such as a silicon wafer, it is known that hydroxyethyl cellulose (HEC) is used as a water-soluble polymer for the purpose of enhancing wettability of the substrate surface in addition to an abrasive such as silica or a basic compound such as ammonia (for example, Patent Literature 1 and 2). In connection thereto, a technology in which another water-soluble polymer is used as an alternative to HEC has also been disclosed (for example, Patent Literature 3).

Document JP 2014 151424 A discloses a polishing composition containing abrasive particles, a water-soluble polymer HEC, a basic compound, a surfactant (PEO-PPO-PEO block copolymer) and water. The weight average molecular weight of the HMC is 200,000 or less. Generation of defects during polishing is effectively suppressed.

[CITATION LIST]

[PATENT LITERATURE]

[PTL 1] Japanese Unexamined Patent Publication (Kokai) No. 2015-159259
[PTL 2] Japanese Unexamined Patent Publication (Kokai) No. 2017-117847
[PTL 3] Japanese Unexamined Patent Publication (Kokai) No. 2013-222863


SUMMARY

[TECHNICAL PROBLEM]

HEC, which is a cellulose derivative and which can be used as a water-soluble polymer in a CMP slurry, enhances the wettability of the surface to be polished of the substrate such as a silicon wafer, and can maintain the hydrophilicity of the surface. Thus, due to the use of HEC, the interaction between the substrate and the slurry occurs suitably, whereby the surface quality of the substrate can be improved. The characteristics of such HEC are extremely effective in the finishing

CMP polishing of substrates, particularly silicon wafers, and combined with convenience such as high dispersibility in aqueous solvents, the use of HEC in polishing compositions is necessary.

Conversely, in order to remove aggregates and impurities present in the polishing composition, in some cases, the CMP slurry is filtered with a filter immediately before the CMP is performed. This is referred to as POU (Point-Of-Use) filter filtration and is an efficient process for improving the surface quality of the substrate to be polished. Furthermore, when the pore diameter of the filter becomes small, smaller aggregates can be removed by filtration, whereby the surface quality of the substrate is further improved. Thus, in polishing compositions, it is desirable to perform POU filter filtration with a filter having a smaller pore diameter. Specifically, it is necessary that the polishing composition have excellent filterability, such as suitable suppression of clogging of the filter, even when a filter having a small pore diameter is used. The CMP slurry used for the chemical-mechanical polishing may be diluted from a state at the time of purchase or storage depending on the desired polishing conditions of the user and the specifications required of the substrate. In this case, since filtration as described above is performed with a diluted CMP slurry, it is important to suppress clogging of the filter and improve POU filter filterability even after dilution.

Due to the characteristics of HEC as described above, it is highly desirable to use HEC, particularly in the slurry used for the CMP of silicon wafers. Conversely, in CMP slurries containing an abrasive, HEC, and a basic component (for example, ammonia), which is generally used as an accelerator for mechanical polishing, HEC tends to adsorb to the abrasive such as silica to form aggregates, whereby dispersibility is reduced as compared with the slurry prior to dilution due to changes in the blending ratio due to dilution, and thus, the filterability tends to be reduced. Thus, in polishing compositions containing HEC, particularly when the composition is diluted, the filterability is inferior to that of polishing compositions containing no HEC, and the POU filter filtration with a smaller pore diameter becomes difficult, whereby the improvement of the surface quality of the substrate is limited. Thus, there is a need to solve the problem of a reduction in POU filter filterability after dilution that occurs in CMP slurries containing an abrasive, HEC and a basic component.

Accordingly, an object of the present invention is to provide a chemical-mechanical polishing composition containing HEC which exhibits improved POU filter filterability allowing filtering even with a POU filter having a small pore diameter after dilution, and a chemical-mechanical polishing method using the same.

[SOLUTION TO PROBLEM]

The present invention, which can achieve the aforementioned object, is defined in appended claims.

[ADVANTAGEOUS EFFECTS OF INVENTION]

According to the present invention, in a chemical-mechanical polishing composition containing an abrasive, a basic component, and an aqueous carrier, HEC having a low weight average molecular weight, more specifically, a weight average molecular weight of 200,000 or less, is used in combination with a surfactant (for example, a nonionic surfactant), whereby a chemical-mechanical polishing composition containing HEC exhibiting improved POU filter filterability after dilution can be provided. Furthermore, according to the present invention, by performing chemical-mechanical polishing using such a chemical-mechanical polishing composition, it is possible to improve the surface quality (surface defects, nano-polishing defects) of the substrate as compared with the case in which a conventional polishing composition is used.

BRIEF DESCRIPTION OF DRAWINGS

FIG. 1 is a graph showing the filtration amount with respect to filtration time for the polishing compositions used in the Examples.
FIG. 2 is a graph showing the filtration amount with respect to filtration time for the polishing compositions used in the Examples.
FIG. 3 is a graph showing the filtration amount with respect to filtration time for the polishing compositions used in the Examples.

DESCRIPTION OF EMBODIMENTS

<Chemical-Mechanical Polishing Composition>

The chemical-mechanical polishing composition of the present invention is for polishing a substrate, and comprises:

an abrasive,
a hydroxyethyl cellulose having a weight average molecular weight of 200,000 or less,
a basic component,
a surfactant, and
an aqueous carrier.

In chemical-mechanical polishing compositions for polishing a substrate such as a silicon wafer, a cellulose derivative commonly used as a water-soluble polymer is extremely useful for enhancing the wettability of the surface of the substrate to be polished. This improvement in wettability is brought about because the cellulose derivative is capable of maintaining the hydrophilicity of the surface of the substrate. When the wettability of the CMP slurry with the substrate surface is increased, the interaction between the slurry and the substrate occurs suitably, and polishing is performed suitably and uniformly, whereby high surface quality (surface defects, nano-polishing defects) can be obtained. In addition, among cellulose derivatives, hydroxyethyl cellulose (HEC) not only exhibits suitable dispersibility and high solubility in an aqueous solvent, but also has excellent compatibility with surfactants (for example, a nonionic surfactant), which is highly practical. Thus, the use of HEC is highly desired in the CMP of a substrate, particularly in CMP slurries used in the CMP finish polishing of silicon wafers. HEC is one kind of cellulose derivative, and since cellulose of natural origin is used as a raw material, water-insoluble matter derived from the cellulose may be brought present, and an abrasive such as silica may be adsorbed on the water-insoluble matter, which produces aggregates. Since HEC itself also exhibits high adsorption property to an abrasive, it has a property of causing aggregation of the abrasive. When polishing is performed with a CMP slurry containing such an aggregate, defects on the surface to be polished may increase, or nano-sized polishing scratches (nano-polishing defects) may be generated, which may adversely affect the surface quality of the substrate.

In order to remove aggregates and impurities present in the polishing composition, filtration can be performed with a filter immediately prior to chemical-mechanical polishing is performed by a CMP device. For example, a filter may be installed between a slurry feed part and the location in which the CMP device is used. Filter filtration in the vicinity of such a location of use is referred to as POU filter filtration, and is an effective process for improving the surface quality of a substrate such as a silicon wafer, and as the pore diameter of the filter becomes smaller, smaller aggregates can be removed by filtration, whereby the surface quality of the substrate is further improved. Furthermore, the polishing composition used for chemical-mechanical polishing may be diluted from a state at the time of purchase or storage according to the desired polishing conditions of the user and the specifications required of the substrate. Thus, it is important to suppress clogging in the filter to improve the POU filter filterability even in the slurry after dilution so that filtration of the polishing composition can be efficiently performed using a filter having a smaller pore diameter. Conventionally, various developments have been made for the improvement of the filterability of polishing compositions (i.e., filterability of the polishing composition prior to dilution). However, as described above, the polishing composition may be diluted immediately prior to use in CMP. In particular, when a polishing composition containing HEC, an abrasive, and a basic component (for example, ammonia), which is useful for the CMP of a silicon wafer, is diluted, the blending ratio of the composition changes, and the HEC tends to adsorb to the abrasive such as silica to form aggregates or to form water-insoluble matter derived from cellulose, and thus, polishing compositions containing HEC are known to be inferior in filterability after dilution compared with polishing compositions containing no HEC. Thus, it is desired to develop a chemical-mechanical polishing composition exhibiting improved POU filter filterability after dilution, and in particular, it is desirable to have a high POU filter filterability which enables filtering of a chemical-mechanical polishing composition containing an abrasive such as silica and a basic component such as ammonia in addition to HEC, which results in excellent wettability but might disadvantageously impact filterability, using a filter having a smaller pore diameter.

Accordingly, the present inventors have conducted various investigations on each constituent element of a polishing composition in order to achieve a polishing composition containing HEC, an abrasive, and a basic component having high POU filter filterability after dilution, and as a result, it has been discovered that by using HEC having a low weight average molecular weight, more specifically, a weight average molecular weight of 200,000 or less, preferably 150,000 or less, in combination with a surfactant, the polishing composition exhibits high filter filterability not only prior to dilution but also, for example, when diluted approximately 20-fold. More specifically, it has been discovered that by using a lower molecular weight HEC, the molecular size of the HEC itself becomes small, and the abrasive to which the HEC attaches and the HEC itself can easily pass through the filter, and by adding a surfactant to improve the dispersion stability of the polishing composition, the abrasive and the HEC can be suitably dispersed and can easily pass through the filter. Such an effect of the present invention is well exhibited regardless of the size (particularly primary particle size) of the abrasive, but the effect is suitably exhibited even when used in combination with an abrasive having an average primary particle diameter of 20 to 40 nm, which can preferably be used in the finishing CMP polishing step of a silicon substrate. Thus, the chemical-mechanical polishing composition according to the present invention is extremely practical, particularly in the finish polishing step of a silicon substrate. It should be noted that naturally the chemical-mechanical polishing composition according to the present invention can be used for other polishing steps and/or for polishing other substrates.

[Abrasive]

The abrasive of the present invention may be any suitable abrasive which is known to a person skilled in the art in the chemical-mechanical polishing of semiconductor substrates such as silicon wafers. The abrasive may be, for example, an abrasive selected from the group consisting of alumina (for example, $\alpha$-alumina, $\gamma$-alumina, $\delta$-alumina, and fumed alumina), silica (for example, colloidal silica, precipitated silica, and fumed silica), ceria, titania, zirconia, germania, magnesia, co-formed products thereof, and arbitrary combinations thereof, though the abrasive is not limited thereto. The abrasive is preferably selected from the group consisting of alumina, silica, ceria, zirconia, and combinations thereof, more preferably silica, in particular colloidal silica or ceria, and most preferably colloidal silica.

In the present invention, the abrasive may have any suitable particle size. Though not particularly limited, the abrasive may have an average primary particle size of, for example, 5 nm or more, 10 nm or more, 15 nm or more, or 20 nm or more. In order to obtain more improved POU filter filterability by sufficiently suppressing aggregation of the abrasive while ensuring the polishing rate, it is preferable that the abrasive have an average primary particle size of 15 nm or more, and more preferably have an average primary particle size of 20 nm or more. The abrasive may have an average primary particle size of 200 nm or less, 150 nm or less, 100 nm or less, 80 nm or less, 60 nm or less, 50 nm or less, or 40 nm or less. In order to obtain more improved POU filter filterability and reduce surface defects, it is preferable that the abrasive have an average primary particle size of 50 nm or less, and more preferably have an average primary particle size of 40 nm or less. Thus, the abrasive may have an average primary particle size in the range of, for example, 5 to 200 nm, 10 to 200 nm, 20 to 200 nm, 5 to 100 nm, 10 to 100 nm, 20 to 100 nm, 5 to 50 nm, 10 to 50 nm, 20 to 50 nm, 5 to 40 nm, 10 to 40 nm or 20 to 40 nm, and from the viewpoint of further improving POU filter filterability, it is particularly preferable that the abrasive have an average primary particle size in the range of 20 to 40 nm. Thus, the most preferred abrasive in the present invention is silica (for example, colloidal silica) having an average primary particle size of 20 to 40 nm.

Further, when the primary particles aggregate to form secondary particles, from the viewpoint of increasing polishing rate and improving the surface quality of a substrate to be polished, the abrasive preferably has an average secondary particle size in the range of 0.02 to 3 $\mu$m, more preferably 0.02 to 1.0 $\mu$m, and most preferably 0.02 to 0.2 $\mu$m. The average primary particle size of the abrasive can be determined by performing image analysis on an image captured with a scanning electron microscope (SEM) or transmission electron microscope (TEM). Furthermore, the average secondary particle size can be measured as a volume average particle size using a laser light scattering method.

The abrasive may be present in the chemical-mechanical polishing composition in a quantity of 0.01% by mass or more, 0.02% by mass or more, 0.05% by mass or more, or 0.1% by mass or more, and 20% by mass or less, 15% by mass or less, 12% by mass or less, or 10% by mass or less based on the mass of the aqueous carrier and all of the components which are dissolved or suspended therein. The abrasive is preferably present in the chemical-mechanical polishing composition in a quantity in the range of 0.01 to 20% by mass, more preferably 0.05 to 15% by mass, and most preferably 0.1 to 10% by mass. The chemical mechanical polishing composition in a concentrated state (prior to dilution) may contain, for example, 1 to 15% by mass, preferably 1 to 10% by mass of an abrasive. Furthermore, the diluted chemical-mechanical polishing composition (at the time of use in polishing) may contain, for example, 0.01 to 3% by mass, preferably 0.01 to 1% by mass of an abrasive.

[Hydroxyethyl Cellulose (HEC)]

In the chemical-mechanical polishing composition according to the present invention, hydroxyethyl cellulose (HEC) is an essential component. HEC can mainly act as a wetting agent. Such a wetting agent is effective for maintaining the hydrophilicity of the surface of a substrate such as a silicon wafer. In the present invention, it is important to set the weight average molecular weight (Mw) of HEC to be low in order to obtain improved POU filter filterability. Specifically, the HEC in the present invention has an Mw of 200,000 or less, preferably has an Mw of 150,000 or less, and more preferably has an Mw of 120,000 or less. By using a low Mw HEC with a surfactant, which is described later, a chemical-mechanical polishing composition which exhibits improved POU filter filterability after dilution of the polishing composition can be provided. When the molecular weight of the HEC increases (for example, Mw: 250,000), particularly at the time of filtration after the polishing composition has been diluted, the filter becomes clogged, whereby the polishing composition is not sufficiently filtered and the POU filter filterability deteriorates. In such a case, the yield of slurry usable for CMP is remarkably lowered, which may lack practicability. Further, it is necessary to wash or replace the filter after each use, and the slurry cannot be cyclically or continuously supplied, which is not preferable in use.

The HEC may be present in the chemical-mechanical polishing composition in a quantity of, for example, 0.001% by mass or more, 0.002% by mass or more, 0.005% by mass or more, or 0.01% by mass or more, and 2.0% by mass or less, 1.5% by mass or less, 1.2% by mass or less, or 1.0% by mass or less, based on the mass of the aqueous carrier and all of the components which are dissolved or suspended therein. The HEC may be present in the chemical-mechanical polishing composition preferably in a quantity of from 0.001 to 2.0% by mass, more preferably from 0.005 to 1.5% by mass, and most preferably from 0.01 to 1.0% by mass.

[Basic Component]

The basic component of the present invention acts chemically on the surface of a semiconductor substrate such as a silicon wafer and can assist mechanical polishing with the abrasive. Though not particularly limited, the basic component may be a compound selected from the group consisting of, for example, ammonia, potassium hydroxide, sodium hydroxide, ammonium carbonate, potassium carbonate, sodium carbonate, methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, tetraethylenepentamine, anhydrous piperazine, piperazine hexahydrate, 1-(2-aminoethyl)piperazine, N-methyl piperazine, and arbitrary combinations thereof. The basic component is preferably selected from the group consisting of ammonia, potassium hydroxide, sodium hydroxide, ammonium carbonate, potassium carbonate, and sodium carbonate. The basic component is more preferably ammonia, potassium hydroxide, or sodium hydroxide, and most preferably ammonia.

The basic component may be present in the chemical-mechanical polishing composition in a quantity of, for example, 0.001% by mass or more, 0.002% by mass or more, 0.005% by mass or more, 0.01% by mass or more, or 0.1% by mass or more, and 5.0% by mass or less, 3.0% by mass or less, 1.5% by mass or less, 1.2% by mass or less, or 1.0% by mass or less based on the mass of the aqueous carrier and all of the components which are dissolved or suspended therein. The basic component is preferably present in the chemical-mechanical polishing composition in a quantity in the range of 0.001 to 5.0% by mass, more preferably 0.005 to 1.5% by mass, and most preferably 0.01 to 1.0% by mass.

[Surfactant]

Though the surfactant of the present invention is an essential component of the chemical-mechanical polishing composition according to the present invention, the type of surfactant may be any suitable surfactant known to those skilled in the art in the chemical-mechanical polishing of semiconductor substrates such as silicon wafers. By using the HEC having a low weight average molecular weight described above and a surfactant in combination, the POU filter filterability of the polishing composition after dilution can be improved. Conversely, if no surfactant is used, dispersibility of the polishing composition is not sufficient, whereby even if an HEC having a low weight average molecular weight is used, the POU filter filterability of the polishing composition after dilution may become insufficient. Though not particularly limited, the surfactant may typically be an anionic surfactant or a nonionic surfactant, and is preferably a nonionic surfactant. The use of a nonionic surfactant as the surfactant is preferable not only to facilitate pH adjustment of but to improve compatibility with HEC. By polishing a substrate such as a silicon wafer using a chemical-mechanical polishing composition containing a surfactant, excellent surface quality (for example, haze) can be achieved.

Though not particularly limited, examples of the nonionic surfactant include polyoxyalkylene alkyl ether (for example, polyoxyethylene isopropyl ether, polyoxyethylene isobutyl ether, polyoxyethylene sec-butyl ether, polyoxyethylene-t-butyl ether, polyoxyethylene isopentyl ether, polyoxyethylene isohexyl ether, polyoxyethylene heptyl ether, polyoxyethylene isoheptyl ether, polyoxyethylene isooctyl ether, polyoxyethylene isononyl ether, polyoxyethylene isodecyl ether, polyoxyethylene oxypropylene 2-propyl heptyl ether, polyoxyethylene undecyl ether, polyoxyethylene isoundecyl ether, polyoxyethylene lauryl ether, polyoxyethylene isolauryl ether, polyoxyethylene tridecyl ether, polyoxyethylene isotridecyl ether, polyoxyethylene tetradecyl ether, polyoxyethylene isotetradecyl ether, polyoxyethylene pentadecyl ether, polyoxyethylene isopentadecyl ether, polyoxypropylene methyl ether, polyoxypropylene ethyl ether, polyoxypropylene butyl ether, and polyoxypropylene-2-ethylhexyl ether); polyoxyalkylene phenyl ether (for example, polyoxyethylene phenyl ether, polyoxyethylene styrenated phenyl ether, polyoxyethylene octylphenyl ether, polyoxyethylene nonylphenyl ether, and polyoxyethylene dodecylphenyl ether); alkylene polyalkylene oxide amine polymers; polyoxyalkylene alkylamines (for example, polyoxyethylene behenylamine, polyoxyethylene stearylamine, polyoxyethylene oleylamine, polyoxyethylene cetylamine, and polyoxyethylene laurylamine); polyoxyalkylene alkyl amides (for example, polyoxyethylene laurylamide, polyoxyethylene stearylamide, and polyoxyethylene oleylamide); copolymers containing ethylene oxide units (EO) and propylene oxide units (PO); polyether polyols (for example, polyethylene glycol, polypropylene glycol, polytetramethylene glycol, alternating copolymers of EO and PO, block copolymers of EO and PO, and random copolymers of EO and PO); polyoxyalkylene fatty acid esters (for example, polyoxyethylene monostearic acid ester, polyoxyethylene distearate ester, polyoxyethylene monooleic acid ester, polyoxyethylene dioleic acid ester, and polyoxyethylene monolauric acid ester); polyethylene glycol fatty acid esters (for example, polyethylene glycol monostearate and polyethylene glycol monooleate); glycerin fatty acid esters (for example, lecithin, polymer emulsifiers, and oil-based glycerin monostearate); polyglycerin fatty acid esters (for example, polyglyceryl monooleate, polyglyceryl pentaoleate, and polyglyceryl decaoleate); polyoxyethylene glycerin fatty acid esters (for example, polyoxyethylene glycerin monostearate); sorbitan fatty acid esters (for example, sorbitan monolaurate, sorbitan monooleate, and sorbitan trioleate); polyoxyethylene sorbitan fatty acid esters (for example, polyoxyethylene sorbitan monostearate and polyoxyethylene sorbitan trioleate); polyoxyethylene sorbitol fatty acid esters (for example, polyoxyethylene sorbitol monolaurate and polyoxyethylene sorbitol tetraoleate); and polyoxyethylene castor oil/hardened castor oil (for example polyoxyethylene

castor oil and polyoxyethylene hardened castor oil). These surfactants may be used along or a combination of two or more thereof may be used.

Though the quantity of the surfactant of the present invention is determined in accordance with the type of the surfactant, the surfactant may be present in the chemical-mechanical polishing composition in a quantity of, for example, 0.01 ppm or more, 0.05 ppm or more, 0.1 ppm or more, 0.5 ppm or more, 1 ppm or more, 2 ppm or more, 5 ppm or more, or 10 ppm or more and 5000 ppm or less, 3000 ppm or less, 1000 ppm or less, 500 ppm or less, 300 ppm or less, 100 ppm or less, based on the mass of the aqueous carrier and all of the components which are dissolved or suspended therein. The surfactant may preferably be present in the chemical-mechanical polishing composition in a quantity of from 0.1 to 5000 ppm (0.00001 to 0.5% by mass), more preferably from 1 to 1000 ppm (0.0001 to 0.1% by mass), and most preferably from 5 to 1000 ppm (0.0005 to 0.1% by mass).

From the viewpoint of achieving more improved POU filter filterability and further improving surface quality, particularly haze reduction, it is preferable that the surfactant in the present invention comprise at least one of an alkylene polyalkylene oxide amine polymer and a polyoxyalkylene alkyl ether. More preferably, the surfactant of the present invention may comprise both an alkylene polyalkylene oxide amine polymer and a polyoxyalkylene alkyl ether. These surfactants are extremely effective surfactants in reducing the haze of the substrate.

(Alkylene Polyalkylene Oxide Amine Polymer)

The chemical-mechanical polishing composition of the present invention preferably comprises an alkylene polyalkylene oxide amine polymer as the surfactant to achieve more improved POU filter filterability and/or excellent haze characteristics. Further, when the chemical-mechanical polishing composition of the present invention contains an alkylene polyalkylene oxide amine polymer, it is more preferable that the alkylene polyalkylene oxide amine polymer have at least two repeating structural units containing a tertiary amine having an alkylene group and a polyalkyleneoxide group bonded to an N atom. As described above, by using the alkylene polyalkylene oxide amine polymer in the chemical-mechanical polishing composition according to the present invention, a greater haze reduction effect can be achieved while obtaining more improved POU filter filterability. Naturally, when an alkylene polyalkylene oxide amine polymer is used in the chemical-mechanical polishing composition, it can be used with other surfactants.

The alkylene polyalkylene oxide amine polymer described above is not particularly limited, and is represented by, for example, the following formula:

[Chem 1]

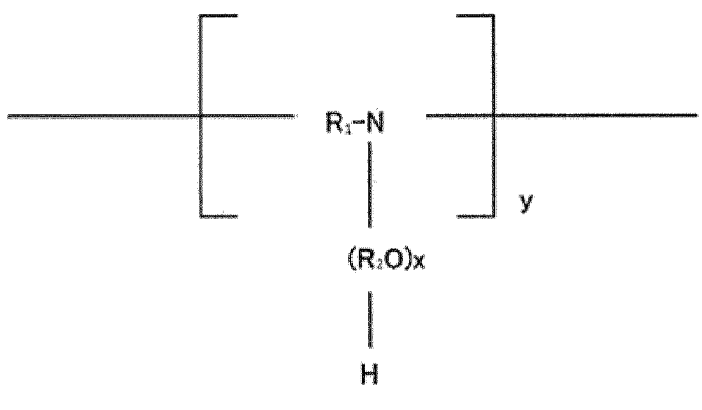

where $R_1$ is a linear or branched $C_1$ to $C_{10}$ alkylene group, preferably a linear or branched $C_1$ to $C_4$ alkylene group, and more preferably an ethylene group, $R_2$ is an alkylene group selected from the group consisting of an ethylene group, a propylene group, a butylene group and combinations thereof, x is an integer of 2 to 1000, preferably 2 to 20, and y is an integer of 2 to 10000, preferably 2 to 500. $R_2$ is preferably selected from an ethylene group and/or a propylene group. When $R_2$ includes both an ethylene group and a propylene group, the ethylene group and the propylene group are preferably present at a molar ratio of 80:20 to 90:10.

The alkylene polyalkylene oxide amine polymer described above preferably has a solubility parameter (SP) of 9 to 10. In the present invention, the solubility parameter (SP) is calculated using Fedors' method, which is described in Ueda et al., Research on Paints, No. 152, October 2010, pp. 41-46.

The alkylene polyalkylene oxide amine polymer can have an average molecular weight of, for example, 5,000 to 100,000 or 10,000 to 80,000. When the average molecular weight thereof is less than 5,000, there is a risk that sufficient haze improvement cannot be achieved. Conversely, when the average molecular weight exceeds 100,000, the effect

brought about by the alkylene polyalkylene oxide amine polymer, for example, the additive dependence on the effect of improving haze, becomes too large, which is not preferable.

The alkylene polyalkylene oxide amine polymer may be included in the chemical-mechanical polishing composition in a quantity of, for example, 1 ppm or more, 2 ppm or more, 5 ppm or more, or 10 ppm or more, and 5000 ppm or less, 3000 ppm or less, 1000 ppm or less, or 500 ppm or less, based on the mass of the aqueous carrier and all of the components which are dissolved or suspended therein. The alkylene polyalkylene oxide amine polymer is preferably present in the chemical-mechanical polishing composition in a quantity in the range of 1 to 5000 ppm (0.0001 to 0.5% by mass), more preferably 2 to 1000 ppm (0.002 to 0.1% by mass), and most preferably 5 to 1000 ppm (0.005 to 0.1% by mass).

The alkylene polyalkylene oxide amine polymer can be produced by any method which is known to a person skilled in the art. For example, the alkylene polyalkylene oxide amine polymer can be produced by the addition polymerization of alkylene oxide to the active hydrogen of a polyamine compound having two or more primary amino groups and/or secondary amino groups and containing 4 to 100 N atoms in the molecule. More specifically, the polyamine compound can be produced by the addition polymerization (graft polymerization) of alkylene oxide at 100 to 180 °C and 1 to 10 atm in the presence of an alkali catalyst. The aspect of the addition polymerization of alkylene oxide to polyamine compound is not particularly limited, and when two or more alkylene oxides are added, the form may be block-like or random.

Examples of the polyamine compound providing the main chain structure include polyethylene polyamines such as triethylenetetramine, tetraethylenepentamine, pentaethylenehexamine, and hexaethyleneheptamine, and polyalkyleneimines such as polyethyleneimine obtained by the polymerization of ethyleneimine. These compounds may be used alone, or the polyamine main chain structure may be formed using a combination of two or more thereof. Examples of the alkylene oxide added to the main chain structure include ethylene oxide, propylene oxide, and butylene oxide. These alkylene oxides may be used alone or in a combination of two or more thereof.

(Polyoxyalkylene Alkyl Ether)

It is preferable that the chemical mechanical polishing composition of the present invention contain a polyoxyalkylene alkyl ether as a surfactant in order to achieve more improved POU filter filterability and/or excellent haze characteristics. Though the polyoxyalkylene alkyl ether may be included as an alternative to the alkylene polyalkylene oxide amine polymer described above, or both may be included, from the viewpoint of improving the POU filter filterability and/or haze characteristics, it is most preferable that both be included. Naturally, when a polyoxyalkylene alkyl ether is used in the chemical mechanical polishing composition, it can be used together with other surfactants. Further, when the chemical mechanical polishing composition of the present invention contains a polyoxyalkylene alkyl ether, the polyoxyalkylene alkyl ether may comprise a polyoxyalkylene alkyl ether represented by the formula (i) $RO\text{-}(AO)_n\text{-}H$, wherein R is a linear or branched $C_1$ to $C_{15}$ alkyl group, A is an alkylene group selected from the group consisting of an ethylene group, a propylene group, and a combination thereof, n represents average addition mol numbers of AO and is 2 to 30. By including such a polyoxyalkylene alkyl ether as an additional component, not only can POU filter filterability be improved, but substrate surface haze can be reduced as compared to the case in which the polyoxyalkylene alkyl ether is not included, and further, a reduction in the wettability of the substrate surface as a result of the accumulation of additional components such as the polyoxyalkylene alkyl ether in the polishing pad can be substantially or completely prevented. Thus, when a chemical-mechanical polishing composition comprising a polyoxyalkylene alkyl ether is used, the generation of surface defects caused by a reduction in the wettability of the substrate surface can be reliably prevented, whereby the life of the polishing pad can be improved.

Even if the carbon number of the R group of formula (i) is 16 or more, regarding specific polyoxyalkylene alkyl ethers, substrate surface haze can be reduced. However, if the carbon number of the R group of formula (i) is 16 or more, since such a polyoxyalkylene alky ether, for example, polyoxyethylene cetyl ether or polyoxyethylene stearyl ether, easily accumulates in the polishing pad, and in some cases, the polyoxyalkylene alkyl ether cannot be completely removed by pad conditioning or the like, which is carried out prior to each polishing process. Thus, there is a risk that the polyoxyalkylene alkyl ether will gradually accumulate in the polishing pad during repeated substrate polishing. The accumulated polyoxyalkylene alkyl ether reduces the wettability of the substrate surface, which itself can cause defects on the substrate surface during polishing. Furthermore, if the wettability of the substrate surface is reduced, polishing debris and other foreign matter are likely to adhere to the substrate, and as a result, may cause defects on the substrate surface.

Thus, in the present invention, the R in formula (i) may be a linear or branched $C_1$ to $C_{15}$ alkyl group, and in order to reduce substrate surface haze and to more reliably prevent a reduction in the wettability of the substrate surface due to the accumulation of polyoxyalkylene alkyl ether in the polishing pad, the R is preferably a linear or branched $C_1$ to $C_{13}$ alkyl group. Furthermore, in another preferable aspect of the present invention, R may be a branched $C_{11}$ to $C_{15}$ alkyl group, a branched $C_{12}$ to $C_{14}$ alkyl group, or a branched $C_{13}$ alkyl group (for example, an isotridecyl group).

The A in formula (i) may be either of an ethylene group and a propylene group, and may be an arbitrary

combination of one or a plurality of ethylene groups and one or a plurality of propylene groups. In a specific preferable aspect of the present invention, A is an ethylene group or a combination of an ethylene group and a propylene group.

n in formula (i) represents average addition mol numbers of AO, and may be, for example, appropriately determined within the range of 2 to 30. From the viewpoint of preventing the reduction in the wettability of the substrate surface due to the accumulation of polyoxyalkylene alkyl ether in the polishing pad, n is preferably a larger value, and may be, for example, 5 or more, 6 or more, 8 or more, 10 or more, 11 or more, or 12 or more. Furthermore, n may be 28 or less, and may be, for example, 25 or less, or 23 or less. Note that in the present invention, the "average addition mol numbers of AO" is also referred to as the average value of the mol number of oxyalkylene units contained in one mol of polyoxyalkylene alkyl ether.

Though not particularly limited, specific examples of the above polyoxyalkylene alkyl ether include polyoxyethylene isopropyl ether, polyoxyethylene isobutyl ether, polyoxyethylene sec-butyl ether, polyoxyethylene t-butyl ether, polyoxyethylene isopentyl ether, polyoxyethylene isohexyl ether, polyoxyethylene heptyl ether, polyoxyethylene isoheptyl ether, polyoxyethylene isooctyl ether, polyoxyethylene isononyl ether, polyoxyethylene isodecyl ether, polyoxyethylene oxypropylene 2-propyl heptyl ether, polyoxyethylene undecyl ether, polyoxyethylene isoundecyl ether, polyoxyethylene lauryl ether, polyoxyethylene isolauryl ether, polyoxyethylene tridecyl ether, polyoxyethylene isotridecyl ether, polyoxyethylene tetradecyl ether, polyoxyethylene isotetradecyl ether, polyoxyethylene pentadecyl ether, and polyoxyethylene isopentadecyl ether.

The above polyoxyalkylene alkyl ether preferably includes at least one of polyoxyethylene isodecyl ether, polyoxyethylene oxypropylene 2-propyl heptyl ether, polyoxyethylene lauryl ether, and polyoxyethylene isotridecyl ether, and most preferably includes at least one of polyoxyethylene oxypropylene 2-propyl heptyl ether, and polyoxyethylene isotridecyl ether. These polyoxyalkylene alkyl ethers may be synthesized by any method known to a person skilled in the art or may be commercially obtained.

In the present invention, the HLB value of the polyoxyalkylene alkyl ether is calculated according to the Griffin method, more specifically, is calculated by the following formula:

$$\text{HLB value} = 20 \times (\text{sum of formula weight of hydrophilic components}) / (\text{molecular weight})$$

The hydrophilic components of the polyoxyalkylene alkyl ether correspond to the polyoxyalkylene, i.e., the $(AO)_n$ portion of formula (i), and thus, it is obvious that the HLB value varies depending on the carbon number of the R group and the average addition mol numbers of the oxyalkylene (AO). However, regarding the effect of the present invention, in particular, an improvement of substrate surface wettability, the carbon number of the R group in formula (i) is the dominant parameter, and thus, the substrate surface wettability is not greatly influenced by the HLB value. Thus, the polyoxyalkylene alkyl ether of the present invention can have any suitable HLB value. In general, the HLB value may be appropriately determined within the range of 12 to 18.

In the present invention, the polyoxyalkylene alkyl ether can have any suitable molecular weight. Though not particularly limited, the polyoxyalkylene alkyl ether can have an average molecular weight of about 100 to about 2,000.

The polyoxyalkylene alkyl ether may be present in the chemical-mechanical polishing composition in a quantity of, for example, 0.01 ppm or more, 0.02 ppm or more, 0.05 ppm or more, or 0.1 ppm or more, and 5000 ppm or less, 3000 ppm or less, 1000 ppm or less, or 500 ppm or less based on the mass of the aqueous carrier and all of the components which are dissolved or suspended therein. The polyoxyalkylene alkyl ether is preferably present in the chemical-mechanical polishing composition in a quantity in the range of 0.1 to 5000 ppm (0.00001 to 0.5% by mass), more preferably 0.1 to 1000 ppm (0.00001 to 0.1% by mass), and most preferably 0.1 to 500 ppm (0.00001 to 0.05% by mass).

[Aqueous Carrier]

The aqueous carrier is used to facilitate the application of all of the components which are dissolved or suspended in the aqueous carrier to a suitable substrate surface to be polished. The aqueous carrier may typically be composed of only water, may include water and a water-soluble solvent, or may be an emulsion. An alcohol, for example, methanol or ethanol, is preferably used as the water-soluble solvent. The aqueous carrier is preferably water, and more preferably deionized water.

The chemical-mechanical polishing composition of the present invention can have any suitable pH, and the specific pH value may be appropriately determined in consideration of polishing rate and the like. For example, the chemical-mechanical polishing composition can have a pH of 7 to 12, and preferably has a pH of 8 to 12, more preferably 8.5 to 12. The pH value can be adjusted by adding a pH adjusting agent as necessary. The pH adjusting agent may be an arbitrary alkaline substance, and may be the same as or different from the above basic component. The pH adjusting agent is preferably selected from the group consisting of ammonia, potassium hydroxide, sodium hydroxide, tetramethylammonium hydroxide, tetraethylammonium hydroxide, ammonium hydrogen carbonate, ammonium carbonate, potassium

hydrogen carbonate, potassium carbonate, sodium hydrogen carbonate, and sodium carbonate. The pH adjusting agent is more preferably ammonia, potassium hydroxide, sodium hydroxide, tetramethylammonium hydroxide, or tetraethylammonium hydroxide, and most preferably potassium hydroxide.

[Water-Soluble Polymer]

The chemical-mechanical polishing composition of the present invention may optionally further include, in addition to HEC, a water-soluble polymer. Though not particularly limited, the water-soluble polymer can be at least one selected from the group consisting of polyvinylpyrrolidone (PVP), polyvinylacetamide, cellulose derivatives (excluding HEC), and polymers containing polyvinyl alcohol structural units, and preferably comprises a polymer containing polyvinyl alcohol structural units.

Though the quantity of the water-soluble polymer (excluding HEC) is determined in accordance with the type of the water-soluble polymer to be used, the water-soluble polymer may be present in the chemical-mechanical polishing composition in a quantity of, for example, 0.1 ppm or more, 1 ppm or more, 2 ppm or more, 5 ppm or more, 10 ppm or more, 20 ppm or more, or 50 ppm or more, and 5000 ppm or less, 3000 ppm or less, 1000 ppm or less, or 500 ppm or less, based on the mass of the aqueous carrier and the all of the components which are dissolved or suspended therein. The water-soluble polymer may preferably be present in the chemical-mechanical polishing composition in a quantity of from 0.1 to 5000 ppm (0.00001 to 0.5% by mass), more preferably from 1 to 3000 ppm (0.0001 to 0.3% by mass), and most preferably from 2 to 1000 ppm (0.0002 to 0.1% by mass).

(Cellulose Derivative)

When a cellulose derivative is used as the water-soluble polymer in addition to HEC, the cellulose derivative can be selected from methyl cellulose, hydroxypropyl cellulose, hydroxypropyl methyl cellulose, and combinations thereof.

(Polymer Containing Polyvinyl Alcohol Structural Units)

In chemical-mechanical polishing, which takes advantage of the mechanical interaction between the substrate and the polishing composition (slurry), when polishing is performed, continuous surface defects such as nano-polishing defects or PID may occur on the substrate due to the abrasive contained in the slurry and/or other particles aggregated in the slurry. In the present invention, in order to reduce continuous surface defects on the substrate such as nano-polishing defects or PID, the chemical-mechanical polishing composition can include a polymer containing polyvinyl alcohol structural units.

The polymer containing polyvinyl alcohol structural units can function as a wetting agent. Thus, in the chemical-mechanical polishing composition of the present invention, in order to maintain substrate surface hydrophilicity, a polymer containing polyvinyl alcohol structural units may be used in addition to HEC. Further, in the polishing composition, the polymer containing polyvinyl alcohol structural units is preferably used together with at least one of the alkylene polyalkylene oxide amine polymer and polyoxyalkylene alkyl ether described above, and is more preferably with both the alkylene polyalkylene oxide amine polymer and the polyoxyalkylene alkyl ether. By using the polymer together with these surfactants, the quality of the slurry is better stabilized.

The polymer containing polyvinyl alcohol structural units may be an arbitrary polymer which contains polyvinyl alcohol structural units. For example, the polymer containing polyvinyl alcohol structural units may simply be polyvinyl alcohol, or may be a polymer containing a polyalkylene oxide such as polyethylene glycol, in addition to polyvinyl alcohol. Further, the polymer containing polyvinyl alcohol structural units may include, for example, polyvinyl alcohol structural units in the main chain or side chain of the polymer, and further, a part of the polyvinyl alcohol structural units may be substituted with acyloxy groups. Examples of the polymer containing polyvinyl alcohol structural units in the polymer main chain include polyvinyl alcohol-polyalkyleneoxide graft copolymers containing polyvinyl alcohol structural units in the polymer main chain and polyalkyleneoxide structural units in the side chain, and the polyalkyleneoxide structural units may include at least one selected from the group consisting of ethylene oxide, propylene oxide, and a combination thereof. In such a copolymer, the polyvinyl alcohol structural units and the polyalkyleneoxide structural units may be present in the range of, for example, a molar ratio of 95:5 to 60:40, or 90:10 to 70:30.

Preferable examples of such a copolymer include polyvinyl alcohol-polyethylene oxide graft copolymers represented by the following formula:

[Chem 2]

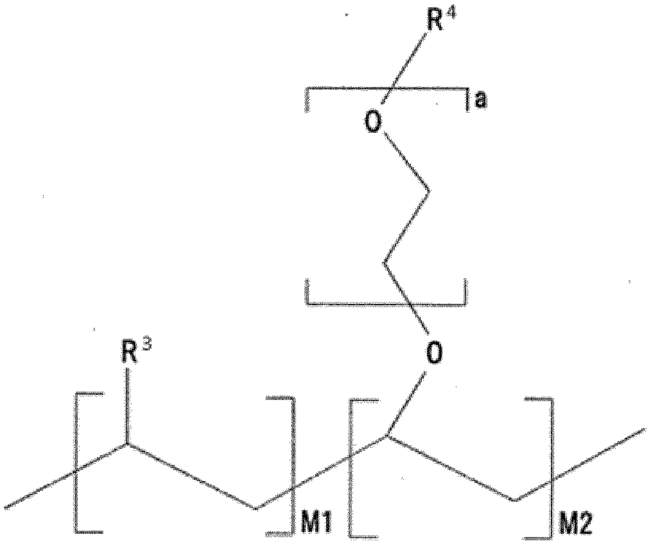

where $R^3$ is a hydroxy group or an acyloxy group represented by R'COO- (where R' is a $C_1$ to $C_8$ alkyl group) (for example, a $CH_3COO$- group), $R^4$ is a hydrogen atom, or an acyl group represented by R"CO- (where R" is a $C_1$ to $C_8$ alkyl group) (for example, a $CH_3CO$- group), a is an integer from 1 to 10,000, M1 and M2 are real numbers between 0 mol% and 100 mol%, and M1 + M2 = 100 mol%. The copolymer of the above formula may have a structure in which $R^3$ is a mix of a hydroxy group and an acyloxy group, and more specifically, a structure in which a part of the acyloxy groups are saponified to hydroxy groups. The degree of saponification in this case is not particularly limited, and may be 70 to 100%, 80 to 100%, 90 to 100%, or 95 to 100%. The values of M1 and M2 can be appropriately determined in accordance with the abundance ratio of the polyvinyl alcohol structural units constituting the main chain and the polyethylene oxide structural units constituting the side chain.

More specific examples of the polyvinyl alcohol-polyethylene oxide graft copolymers of the above formula include polyvinyl alcohol-polyethylene oxide graft copolymers represented by the following formula:

[Chem 3]

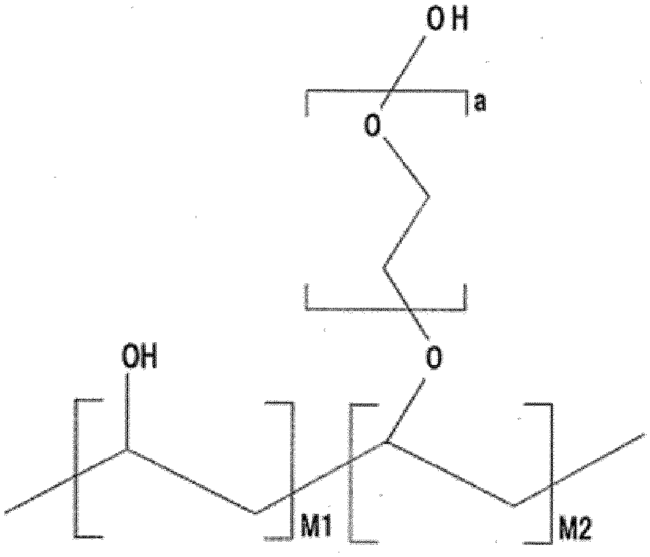

where a is an integer from 1 to 10,000, M1 and M2 are real numbers between 0 mol% and 100 mol%, and M1 + M2 = 100

mol%. A part of the hydroxy groups of the polyvinyl alcohol structural units constituting the main chain of the above formula may be substituted with acyloxy groups represented by R'COO- (where R' is a $C_1$ to $C_8$ alkyl group), and likewise, a part of the terminal hydroxy groups of the polyethylene oxide structural units constituting the side chain of the above formula may be substituted with acyl groups represented by R"CO- (where R" is a $C_1$ to $C_8$ alkyl group).

Examples of the polymer containing polyvinyl alcohol structural units in the polymer side chain include polyvinyl alcohol-polyalkyleneoxide graft copolymers containing polyalkyleneoxide structural units in the main chains and polyvinyl alcohol structural units in the side chain, and the polyalkyleneoxide structural units may include at least one selected from the group consisting of ethylene oxide, propylene oxide, and a combination thereof. In such a copolymer, the polyvinyl alcohol structural units and the polyalkyleneoxide structural units may be present in the range of, for example, a molar ratio of 95:5 to 60:40 or 90:10 to 70:30.

Preferable examples of such a copolymer include polyvinyl alcohol-polyethylene oxide graft copolymers represented by, for example, the following formula:

[Chem 4]

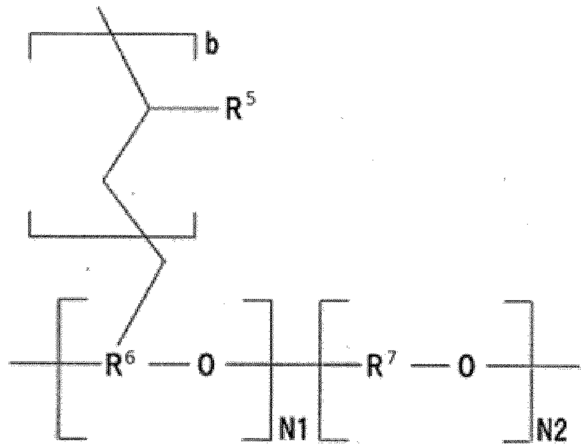

where $R^5$ is a hydroxy group, or an acyloxy group represented by R'COO- (where R' is a $C_1$ to $C_8$ alkyl group) (for example, a $CH_3COO$- group), $R^6$ and $R^7$ are each independently a linear or branched $C_2$ to $C_3$ alkylene group, b is an integer from 2 to 10,000, N1 and N2 are real numbers between 0 mol% and 100 mol%, and N1 + N2 = 100 mol%. The copolymer of the above formula may have a structure in which R is a mix of a hydroxy group and an acyloxy group, and more specifically, a structure in which a part of the acyloxy groups are saponified to hydroxy groups. The degree of saponification in this case is not particularly limited, and may be 70 to 100%, 80 to 100%, 90 to 100% or 95 to 100%. The values of N1 and N2 can be appropriately determined in accordance with the abundance ratio of the polyethylene oxide structural units constituting the main chain and the polyvinyl alcohol structural units constituting the side chain.

More specific examples of the polyvinyl alcohol-polyethylene oxide graft copolymer of the above formula include polyvinyl alcohol-polyethylene oxide graft copolymers represented by the following formula:

[Chem 5]

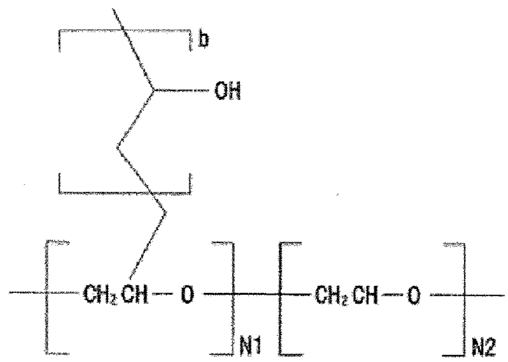

where b is an integer from 2 to 10,000, N1 and N2 are real numbers between 0 mol% and 100 mol%, and N1 + N2 = 100 mol%. A part of the hydroxy groups of the polyvinyl alcohol structural units constituting the side chain of the above formula

may be substituted with acyloxy groups represented by R'COO- (where R' is a $C_1$ to $C_8$ alkyl group).

When the polymer containing polyvinyl alcohol structural units is polyvinyl alcohol or a mixture of polyvinyl alcohol and polyalkylene oxide, the polyvinyl alcohol and polyalkylene oxide can have an average molecular weight of, for example, 1,000 to 10,000,000. Conversely, when the polymer containing polyvinyl alcohol structural units is the polyvinyl alcohol-polyethylene oxide graft copolymer described above, the polyvinyl alcohol-polyethylene oxide graft copolymer can have an average molecular weight of, for example, 5,000 to 500,000, 10,000 to 300,000, or 10,000 to 200,000.

The polymer containing polyvinyl alcohol structural units may be present in the chemical-mechanical polishing composition in a quantity of, for example, 0.1 ppm or more, 1 ppm or more, 2 ppm or more, or 5 ppm or more, and 5000 ppm or less, 3000 ppm or less, 1000 ppm or less, or 500 ppm or less based on the mass of the aqueous carrier and all of the components which are dissolved or suspended therein. The polymer containing polyvinyl alcohol structural units is preferably present in the chemical-mechanical polishing composition in a quantity in the range of 0.1 to 5000 ppm (0.00001 to 0.5% by mass), more preferably 1 to 3000 ppm (0.0001 to 0.3% by mass), and most preferably 2 to 1000 ppm (0.0002 to 0.1% by mass).

[Other Additives]

The chemical-mechanical polishing composition according to the present invention may optionally further comprise other additives, for example, a polishing rate accelerator and a chelating agent. Examples of the polishing rate accelerator include hydroxamic acids (for example, acetohydroxamic acid), nitrogen-containing heterocyclic compounds (for example, triazoles such as 1,2,4-triazole) and combinations thereof. Examples of the chelating agent include organic acids such as oxalic acid, citric acid, malonic acid, succinic acid, glutaric acid, adipic acid, tartaric acid, and phthalic acid, amino acids such as glycine, serine, proline, leucine, alanine, asparagine, glutamine, valine, and lysine, and polyamine composites such as ethylenediaminetetraacetic acid (EDTA), hydroxyethylethylenediaminetriacetic acid (HEDTA), nitrilotriacetic acid, iminodiacetic acid, and diethylenetriaminepentaacetic acid (DTPA).

[Substrate Chemical-Mechanical Polishing Method]

The substrate chemical-mechanical polishing method of the present invention comprises:

contacting a substrate with a polishing pad and the chemical-mechanical polishing composition described above,
moving the polishing pad relative to the substrate with the chemical-mechanical polishing composition therebetween, and
abrading at least a portion of the substrate to polish the substrate.

The method for chemically-mechanically polishing a substrate of the present invention is particularly suitable when used along with a chemical-mechanical polishing (CMP) device. Typically, such devices comprise a platen having a velocity resulting from movement, rotation, and linear or circular motion during use, a polishing pad which contacts the platen and which moves with the platen when the platen moves, and a carrier that holds the substrate to be polished by contacting and moving relative to the surface of the polishing pad. Substrate polishing is carried out by contacting a polishing pad and the chemical-mechanical polishing composition of the present invention with a substrate, and thereafter, the polishing pad is moved relative to the substrate so that at least a portion of the substrate is abraded to polish the substrate.

A substrate can be levelled or polished with any suitable polishing pad and the chemical-mechanical polishing composition. The substrate may be not only a silicon substrate, but also a silicon substrate on which a polysilicon film, an $SiO_2$ film, or a metal wiring film is formed, a sapphire substrate, an SiC substrate, a GaAs substrate, a GaN substrate, or a substrate for forming TSV. Examples of suitable polishing pads include woven and nonwoven polishing pads. Further, suitable polishing pads can include suitable polymers having varying densities, hardnesses, thicknesses, compressibilities, resistance to compression, and compressive moduli. Examples of suitable polymers include polyvinyl chloride, polyvinyl fluoride, nylon, fluorocarbon, polycarbonate, polyester, polyacrylate, polyether, polyethylene, polyamide, polyurethane, polystyrene, polypropylene, co-formed products thereof, and mixtures thereof.

In addition to a method in which a slurry of the chemical-mechanical polishing composition is prepared in advance and polishing is performed with a polishing pad while supplying the slurry to a substrate, the method of the present invention may be carried out by a method in which a diluent and a slurry stock solution are supplied to a polishing pad, and a slurry for polishing is prepared in the vicinity of the polishing pad.

The present invention will be described in more detail below by way of the Examples. However, the present invention is not limited by these Examples in any way.

EXAMPLES

In the Examples below, various chemical-mechanical polishing compositions were prepared, and the POU filter filterability of each composition was evaluated by performing a filter filtration test using a diluted product thereof, and for some chemical-mechanical polishing compositions, light point defects (LPD) and nano-polishing defects of the surface to be polished when the silicon wafer was polished were also evaluated.

[Preparation of Polishing Composition of Example 1]

5.0% by mass of colloidal silica (average primary particle size: approximately 25 nm, average secondary particle size: approximately 45 nm), 0.20% by mass of ammonia, 0.28% by mass of HEC (weight average molecular weight: 120,000), and 0.050% by mass of an alkylene polyalkylene oxide amine polymer (ethylene oxide:propylene oxide = 8:2, average nitrogen number: 5, molecular weight = 46,000) were added to water to prepare the polishing composition of Example 1.

[Preparation of Polishing Composition of Example 2]

The polishing composition of Example 2 was prepared in the same manner as the polishing composition of Example 1, except that the alkylene polyalkylene oxide amine polymer of the polishing composition of Example 1 was changed to 0.005% by mass of polyoxyethylene isotridecyl ether (carbon chain length: 13, branched chain, ethylene oxide = 8).

[Preparation of Polishing Composition of Example 3]

The polishing composition of Example 3 was prepared in the same manner as the polishing composition of Example 1, except that 0.005% by mass of polyoxyethylene isotridecyl ether (carbon chain length: 13, branched chain, ethylene oxide = 8) and 0.010% by mass of a polyvinyl alcohol-polyethylene oxide graft copolymer (80:20 mol%, molecular weight: 93,600, degree of saponification: 98.5%, main chain: polyvinyl alcohol, side chain: polyethylene oxide) as a water-soluble polymer were added to the polishing composition of Example 1.

[Preparation of Polishing Composition of Comparative Example 1]

5.0% by mass of colloidal silica (average primary particle size: approximately 25 nm, average secondary particle size: approximately 45 nm), 0.20% by mass of ammonia, and 0.28% by mass of HEC (weight average molecular weight: 250,000) were added to water to prepare the polishing composition of Comparative Example 1.

[Preparation of Polishing Composition of Comparative Example 2]

The polishing composition of Comparative Example 2 was prepared in the same manner as the polishing composition of Comparative Example 1, except that the weight average molecular weight of the HEC of the polishing composition of Comparative Example 1 was changed from 250,000 to 120,000.

[Preparation of Polishing Composition of Comparative Example 3]

The polishing composition of Comparative Example 3 was prepared in the same manner as the polishing composition of Comparative Example 1, except that 0.050% by mass of the alkylene polyalkylene oxide amine polymer used in Example 3, 0.005% by mass of a polyoxyethylene isotridecyl ether, and 0.010% by mass of a polyvinyl alcohol-polyethylene oxide graft copolymer were added to the components of the polishing composition of Comparative Example 1.

The configurations of the polishing compositions of Examples 1 to 3 and Comparative Examples 1 to 3 are shown in Table 1 below. In the table, "silica size" represents the average primary particle size of colloidal silica, "HEC Mw" represents the weight average molecular weight of the HEC, "surfactant A" represents the alkylene polyalkylene oxide amine polymer, and "surfactant B" represents polyoxyethylene isotridecyl ether.

[Table 1]

| Table 1: Polishing Compositions of Examples 1 to 3 and Comparative Examples 1 to 3] | | | | |
|---|---|---|---|---|
| Polishing Composition | Silica Size | HEC Mw | Surfactant A | Surfactant B |
| Ex 1 | 25 nm | 120,000 | Yes | No |
| Ex 2 | 25 nm | 120,000 | No | Yes |
| Ex 3 | 25 nm | 120,000 | Yes | Yes |
| Comp Ex 1 | 25 nm | 250,000 | No | No |
| Comp Ex 2 | 25 nm | 120,000 | No | No |
| Comp Ex 3 | 25 nm | 250,000 | Yes | Yes |

Next, the average primary particle size of colloidal silica was changed to prepare the polishing compositions of Example 4 and Comparative Examples 4 to 6 and the polishing compositions of Example 5 and Comparative Example 7 below in the same manner as the polishing compositions of Examples 1 to 3 and Comparative Examples 1 to 3 above.

[Table 2]

| Table 2: Polishing Compositions of Example 4 and Comparative Examples 4 to 6] | | | | |
|---|---|---|---|---|
| Polishing Composition | Silica Size | HEC Mw | Surfactant A | Surfactant B |
| Ex 4 | 35 nm | 120,000 | Yes | Yes |
| Comp Ex 4 | 35 nm | 250,000 | No | No |
| Comp Ex 5 | 35 nm | 120,000 | No | No |
| Comp Ex 6 | 35 nm | 250,000 | Yes | Yes |

[Table 3]

| [Table 3: Polishing Compositions of Example 5 and Comparative Example 7] | | | | |
|---|---|---|---|---|
| Polishing Composition | Silica Size | HEC Mw | Surfactant A | Surfactant B |
| Ex 5 | 15 nm | 120,000 | Yes | Yes |
| Comp Ex 7 | 15 nm | 250,000 | Yes | Yes |

[POU Filter Filtration Evaluation].

Each of the polishing compositions described in Tables 1 to 3 above was diluted 20-fold with deionized water to perform a filter filtration evaluation of the polishing composition after dilution, and the POU filter filterability was evaluated. Filtration was carried out using "Ultipore® N66" (diameter: 47 mm, rated filtration accuracy: 0.2 μm) manufactured by Nippon Pole Co., Ltd., under the conditions of evaluation temperature: 20 °C, filtration differential pressure: 100 kPa (constant pressure filtration). For each polishing composition, a filter filtration evaluation was performed under the above conditions, and the filtration amount (throughput) (g) as a function of time (seconds) after the start of filtration was evaluated. The results obtained for each polishing composition in Tables 1 to 3 are shown in FIGS. 1 to 3.

With reference to Table 1 and FIG. 1, it can be understood that Examples 1 to 3, in which an HEC having an Mw of 200,000 or less was used along with a surfactant, had an increased filtration amount with respect to elapsed time and improved POU filter filterability as compared to Comparative Examples 1 to 3, in which an HEC having an Mw exceeding 200,000 was used and/or no surfactant was used. More specifically, in comparison between the filtration amounts (throughputs) after 600 seconds for the compositions, Example 1: 401 g, Example 2: 219 g, Example 3: 353 g, Comparative Example 1: 18 g, Comparative Example 2: 165 g, and Comparative Example 3: 20 g, it was discovered that Examples 1 to 3 had superior POU filter filterability as compared with Comparative Examples 1 to 3. In particular, POU filter filterability was remarkably improved when an alkylene polyalkylene oxide amine polymer was used.

With reference to Table 2 and FIG. 2, it can be understood that, as in FIG. 1, even when the average primary particle size of the abrasive was 35 nm, Example 4, in which an HEC having an Mw of 200,000 or less was used along with a surfactant, had improved POU filter filterability as compared to Comparative Examples 4 to 6, in which an HEC having an MW exceeding 200,000 was used and/or no surfactant was used. More specifically, in comparison between the filtration

amounts (throughputs) after 600 seconds, Example 4: 479 g, Comparative Example 4: 18 g, Comparative Example 5: 276 g, and Comparative Example 6: 232 g, it was discovered that Example 4 had superior POU filter filterability as compared with Comparative Examples 4 to 6.

With reference to Table 3 and FIG. 3, it can be understood that, as in FIGS. 1 and 2, even when the average primary particle size of the abrasive was 15 nm, Example 5, in which an HEC having an Mw of 200,000 or less was used along with a surfactant, had improved POU filter filterability as compared with Comparative Example 7, in which no surfactant was used. More specifically, in comparison between the filtration amounts (throughputs) after 600 seconds, Example 5: 199 g and Comparative Example 7: 40 g, it was discovered that Example 5 had superior POU filter filterability as compared with Comparative Example 7.

In the polishing composition according to the present invention, in which HEC having a low weight average molecular weight and a surfactant were used, despite the fact that the polishing composition contains HEC, clogging of the filter can be sufficiently suppressed, and sufficient POU filter filterability can be achieved even when a filter having a small pore size is used. Furthermore, comparing filterability between silica sizes with the same component composition, it was discovered that the larger the primary particle size, the better the filterability. The optimum particle size can be selected (used) in accordance with the balance between the desired filtration performance and the polishing performance. For example, when the surface quality of the substrate is more important, it is preferable to use silica having a small primary particle size.

[Evaluation of Surface Quality After CMP]

The polishing composition of Example 3 and the polishing composition of Comparative Example 3 were diluted 20-fold with deionized water, each polishing composition after dilution was filtered with the filter described above, and a silicon wafer substrate was then subjected to chemical-mechanical polishing (CMP) using the slurry after filtration to evaluate the surface quality (light point defects (LPD), nano-polishing defects) of the silicon wafer after polishing.

[Polishing Operation]

First, 12-inch p-type silicon wafers (silicon substrate) having a resistivity of 0.1 to 100 Ω·cm and <100> crystal orientation were washed with hydrofluoric acid (0.5%) at 23 °C for 2 minutes to remove the natural oxide films therefrom, and thereafter, the obtained silicon wafers were subjected to chemical-mechanical polishing treatment under the following conditions using slurries prepared by diluting the polishing composition of Example 3 and the polishing composition of Comparative Example 3 by a factor of 20 (mass ratio) with pure water. The pHs of the diluted slurries were adjusted to about 10 with potassium hydroxide.

| | |
|---|---|
| (1) CMP device: | 12-inch single-sided polishing machine, Okamoto Machine Works SPP800S |
| (2) Wafer head: | Template method |
| (3) Polishing pad: | POLYPAS 27NX-PS manufactured by Fujibo Ehime, Co., Ltd. |
| (4) Plate rotation speed: | 31 rpm |
| (5) Polishing head rotation speed: | 33 rpm |
| Polishing pressure: | (6) 2.2 psi = 152 g/cm$^2$ = 15 kPa |
| (7) Slurry supply amount: | 500 mL/min (free-flowing) |

After polishing, the silicon wafers were batch-washed for 20 minutes at 23 °C using SC-1 (a solution of ammonia (29% by mass aqueous solution) : hydrogen peroxide (31% by mass aqueous solution) : pure water = 2:1:10 (volume ratio)). Next, the silicon wafers were scrubbed using SC-1 (a solution of ammonia (29% by mass aqueous solution) : hydrogen peroxide (31% by mass aqueous solution) : pure water = 1:4:20 (volume ratio)) and a PVA brush at 23 °C using an SC-200S manufactured by Shibaura Mechatronics, and thereafter rinsed with pure water.

[Defect Measurement]

Further, the formation of light point defects (LPD) of the polished silicon was examined. More specifically, regarding the LPD, Surfscan SP2 manufactured by KLA Tencor was likewise used, and the value of the LPD in the dark field composite oblique incident channel (DCO) was used. Nano-polishing defects were defined as the amount of signal with a scattering intensity that was less intense than the LPD signal and was locally stronger than the baseline intensity. The corresponding signal observed in the set area was counted and judged.

In the polishing composition of Example 3, the presence of nano-polishing defects was improved by approximately 8% and the presence of LPD was improved by approximately 2% while the polishing rate was maintained to an equivalent degree as compared with the polishing composition of Comparative Example 3. Thus, the chemical-mechanical polishing composition according to the present invention not only has high POU filter filterability and high practicability but also can improve the surface quality of the substrate.

## Claims

1. A chemical-mechanical polishing composition for polishing a substrate, comprising:

   an abrasive having a primary particle size of 20 to 40 nm,
   a hydroxyethyl cellulose having a weight average molecular weight of 200,000 or less,
   a basic component,
   a surfactant comprising at least one of an alkylene polyalkylene oxide amine polymer and a polyoxyalkylene alkyl ether, wherein the alkylene polyalkylene oxide amine polymer contains at least two repeating structural units containing a tertiary amine having an alkylene group and a polyalkyleneoxide group bound to an N atom, and the polyoxyalkylene alkyl ether is represented by the formula (i) $RO-(AO)_n-H$, wherein R is a branched $C_{11}$ to $C_{15}$ alkyl group, A is an alkylene group selected from the group consisting of an ethylene group, a propylene group, and a combination thereof, n represents average addition mol numbers of AO and is 2 to 30, and
   an aqueous carrier.

2. The chemical-mechanical polishing composition of claim 1, wherein the hydroxyethyl cellulose has a weight average molecular weight of 150,000 or less.

3. The chemical-mechanical polishing composition of claim 1 or 2, wherein the surfactant comprises both of the alkylene polyalkylene oxide amine polymer and the polyoxyalkylene alkyl ether.

4. The chemical-mechanical polishing composition of claim 1 or 2, wherein the surfactant comprises an alkylene polyalkylene oxide amine polymer.

5. The chemical-mechanical polishing composition of claim 1 or 2, wherein the surfactant comprises a polyoxyalkylene alkyl ether.

6. The chemical-mechanical polishing composition of any one of claims 1 to 5 further comprising:
   a water-soluble polymer comprising a polymer containing a polyvinyl alcohol structural unit.

7. The chemical-mechanical polishing composition of claim 6, wherein the polymer containing a polyvinyl alcohol structural unit is a polyvinyl alcohol-polyalkyleneoxide graft copolymer containing a polyvinyl alcohol structural unit in a main chain and a polyalkyleneoxide structural unit in a side chain, or a polyvinyl alcohol-polyalkyleneoxide graft copolymer containing a polyalkyleneoxide structural unit in a main chain and a polyvinyl alcohol structural unit in a side chain.

8. The chemical-mechanical polishing composition of any one of claims 1 to 7, wherein the abrasive is selected from the group consisting of alumina, silica, ceria, zirconia and a combination thereof.

9. The chemical-mechanical polishing composition of claim 1, comprising:

   a silica having a primary particle size of 20 to 40 nm,
   a hydroxyethyl cellulose having a weight average molecular weight of 150,000 or less, ammonia,
   a surfactant comprising at least one of an alkylene polyalkylene oxide amine polymer and a polyoxyalkylene alkyl ether, wherein the alkylene polyalkylene oxide amine polymer contains at least two repeating structural units containing a tertiary amine having an alkylene group and a polyalkyleneoxide group bound to an N atom, and the polyoxyalkylene alkyl ether is represented by the formula (i) $RO-(AO)_n-H$, wherein R is a branched $C_{11}$ to $C_{15}$ alkyl group, A is an alkylene group selected from the group consisting of an ethylene group, a propylene group, and a combination thereof, n represents average addition mol numbers of AO and is 2 to 30,
   a water-soluble polymer comprising a polymer containing a polyvinyl alcohol structural unit, and
   an aqueous carrier.

10. The chemical-mechanical polishing composition of any one of claims 1 to 9, wherein the substrate is a silicon substrate.

11. A method of chemically-mechanically polishing a substrate, comprising:

contacting a substrate with a polishing pad and the chemical-mechanical polishing composition of any one of claims 1 to 10,
moving the polishing pad relative to the substrate with the chemical-mechanical polishing composition therebetween, and
abrading at least a portion of the substrate to polish the substrate.

12. The method of chemically-mechanically polishing a substrate of claim 11, wherein the method comprises, before the contacting step, diluting the chemical-mechanical polishing composition and then filtering it with a filter having a pore diameter of 5 μm or less.

**Patentansprüche**

1. Chemisch-mechanische Polierzusammensetzung zum Polieren eines Substrats, umfassend:

einen Abrasivstoff mit einer Primärpartikelgröße von 20 bis 40 nm,
eine Hydroxyethylcellulose mit einem gewichtsgemittelten Molekulargewicht von 200.000 oder weniger,
eine basische Komponente,
ein Tensid umfassend wenigstens eines von einem Alkylenpolyalkylenoxidaminpolymer und einem Polyoxyalkylenalkylether, wobei das Alkylenpolyalkylenoxidaminpolymer wenigstens zwei sich wiederholende Struktureinheiten enthält, die ein tertiäres Amin mit einer Alkylengruppe und einer an ein N-Atom gebundenen Polyalkylenoxidgruppe enthalten, und der Polyoxyalkylenalkylether durch die Formel (i) $RO-(AO)_n-H$ dargestellt wird, wobei R eine verzweigte $C_{11}$- bis $C_{15}$-Alkylgruppe ist, A eine Alkylengruppe ausgewählt aus der Gruppe bestehend aus einer Ethylengruppe, einer Propylengruppe und einer Kombination ist, n mittlere Additions-Molzahlen von AO darstellt und 2 bis 30 beträgt, und
einen wässrigen Träger.

2. Chemisch-mechanische Polierzusammensetzung nach Anspruch 1, wobei die Hydroxyethylcellulose ein gewichtsmittleres Molekulargewicht von 150.000 oder weniger aufweist.

3. Chemisch-mechanische Polierzusammensetzung nach Anspruch 1 oder 2, wobei das Tensid sowohl das Alkylenpolyalkylenoxidaminpolymer als auch den Polyoxyalkylenalkylether umfasst.

4. Chemisch-mechanische Polierzusammensetzung nach Anspruch 1 oder 2, wobei das Tensid ein Alkylenpolyalkylenoxidaminpolymer umfasst.

5. Chemisch-mechanische Polierzusammensetzung nach Anspruch 1 oder 2, wobei das Tensid einen Polyoxyalkylenalkylether umfasst.

6. Chemisch-mechanische Polierzusammensetzung nach einem der Ansprüche 1 bis 5, ferner umfassend:
ein wasserlösliches Polymer umfassend ein Polymer, das eine Polyvinylalkohol-Struktureinheit enthält.

7. Chemisch-mechanische Polierzusammensetzung nach Anspruch 6, wobei das Polymer, das eine Polyvinylalkohol-Struktureinheit enthält, ein Polyvinylalkohol-Polyalkylenoxid-Pfropfcopolymer, das eine Polyvinylalkohol-Struktureinheit in einer Hauptkette und eine Polyalkylenoxid-Struktureinheit in einer Seitenkette enthält, oder ein Polyvinylalkohol-Polyalkylenoxid-Pfropfcopolymer, das eine Polyalkylenoxid-Struktureinheit in einer Hauptkette und eine Polyvinylalkohol-Struktureinheit in einer Seitenkette enthält, ist.

8. Chemisch-mechanische Polierzusammensetzung nach einem der Ansprüche 1 bis 7, wobei der Abrasivstoff ausgewählt ist aus der Gruppe bestehend aus Aluminiumoxid, Siliciumdioxid, Cerdioxid, Zirkoniumdioxid und einer Kombination davon.

9. Chemisch-mechanische Polierzusammensetzung nach Anspruch 1, umfassend:

Siliciumdioxid mit einer Primärpartikelgröße von 20 bis 40 nm,
eine Hydroxyethylcellulose mit einem gewichtsgemittelten Molekulargewicht von 150.000 oder weniger, Ammoniak,
ein Tensid umfassend wenigstens eines von einem Alkylenpolyalkylenoxidaminpolymer und einem Polyoxyalkylenalkylether, wobei das Alkylenpolyalkylenoxidaminpolymer wenigstens zwei sich wiederholende Struktureinheiten enthält, die ein tertiäres Amin mit einer Alkylengruppe und einer an ein N-Atom gebundenen Polyalkylenoxidgruppe enthalten, und
der Polyoxyalkylenalkylether durch die Formel (i) $RO-(AO)_n-H$ dargestellt wird, wobei R eine verzweigte $C_{11}$- bis $C_{15}$-Alkylgruppe ist, A eine Alkylengruppe ausgewählt aus der Gruppe bestehend aus einer Ethylengruppe, einer Propylengruppe und einer Kombination ist, n mittlere Additions-Molzahlen von AO darstellt und 2 bis 30 beträgt,
ein wasserlösliches Polymer umfassend ein Polymer, das eine Polyvinylalkohol-Struktureinheit enthält, und
einen wässrigen Träger.

**10.** Chemisch-mechanische Polierzusammensetzung nach einem der Ansprüche 1 bis 9, wobei das Substrat ein Siliciumsubstrat ist.

**11.** Verfahren zum chemisch-mechanischen Polieren eines Substrats, umfassend:

Inkontaktbringen eines Substrats mit einem Polierkissen und der chemisch-mechanischen Polierzusammensetzung nach einem der Ansprüche 1 bis 10,
Bewegen des Polierkissens relativ zu dem Substrat mit der chemisch-mechanischen Polierzusammensetzung dazwischen, und
Abschleifen wenigstens eines Teils des Substrats, um das Substrat zu polieren.

**12.** Verfahren zum chemisch-mechanischen Polieren eines Substrats nach Anspruch 11, wobei das Verfahren vor dem Schritt des Inkontaktbringens Verdünnen der chemisch-mechanischen Polierzusammensetzung und dann Filtrieren davon mit einem Filter mit einem Porendurchmesser von 5 μm oder weniger umfasst.

## Revendications

**1.** Composition de polissage mécano-chimique pour polir un substrat, comprenant :

un abrasif ayant une taille de particule primaire de 20 à 40 nm,
une hydroxyéthylcellulose ayant un poids moléculaire moyen en poids de 200 000 ou moins,
un composant de base,
un tensioactif comprenant au moins l'un parmi un polymère de type alkylène poly(oxyde d'alkylène) amine et un éther d'alkyle de polyoxyalkylène, le polymère de type alkylène poly(oxyde d'alkylène) amine contenant au moins deux motifs structuraux répétitifs contenant une amine tertiaire ayant un groupe alkylène et un groupe poly(oxyde d'alkylène) lié à un atome de N, et l'éther d'alkyle de polyoxyalkylène étant représenté par la formule (i) $RO-(AO)_n-H$, R étant un groupe $C_{11}$ à $C_{15}$ alkyle ramifié, A étant un groupe alkylène choisi dans le groupe constitué par un groupe éthylène, un groupe propylène et une combinaison correspondante, n représentant des nombres de moles d'addition de AO moyens et étant 2 à 30, et
un support aqueux.

**2.** Composition de polissage mécano-chimique selon la revendication 1, dans laquelle l'hydroxyéthylcellulose a un poids moléculaire moyen en poids de 150 000 ou moins.

**3.** Composition de polissage mécano-chimique selon la revendication 1 ou 2, dans laquelle le tensioactif comprend à la fois le polymère de type alkylène poly(oxyde d'alkylène) amine et l'éther d'alkyle de polyoxyalkylène.

**4.** Composition de polissage mécano-chimique selon la revendication 1 ou 2, dans laquelle le tensioactif comprend un polymère de type alkylène poly(oxyde d'alkylène) amine.

**5.** Composition de polissage mécano-chimique selon la revendication 1 ou 2, dans laquelle le tensioactif comprend un éther d'alkyle de polyoxyalkylène.

**6.** Composition de polissage mécano-chimique selon l'une quelconque des revendications 1 à 5 comprenant en outre :

un polymère soluble dans l'eau comprenant un polymère contenant un motif structural de poly(alcool vinylique).

**7.** Composition de polissage mécano-chimique selon la revendication 6, dans laquelle le polymère contenant un motif structural de poly(alcool vinylique) est un copolymère greffé poly(alcool vinylique)-poly(oxyde d'alkylène) contenant un motif structural de poly(alcool vinylique) dans une chaîne principale et un motif structural de poly(oxyde d'alkylène) dans une chaîne latérale, ou un copolymère greffé de poly(alcool vinylique)-poly(oxyde d'alkylène) contenant un motif structural de poly(oxyde d'alkylène) dans une chaîne principale et un motif structural de poly(alcool vinylique) dans une chaîne latérale.

**8.** Composition de polissage mécano-chimique selon l'une quelconque des revendications 1 à 7, dans laquelle l'abrasif est choisi dans le groupe constitué par l'alumine, la silice, l'oxyde de cérium, la zircone et une combinaison de ceux-ci.

**9.** Composition de polissage mécano-chimique selon la revendication 1, comprenant :

une silice ayant une taille de particule primaire de 20 à 40 nm,
une hydroxyéthylcellulose ayant un poids moléculaire moyen en poids de 150 000 ou moins, ammoniac,
un tensioactif comprenant au moins l'un parmi un polymère de type alkylène poly(oxyde d'alkylène) amine et un éther d'alkyle de polyoxyalkylène, le polymère de type alkylène poly(oxyde d'alkylène) amine contenant au moins deux motifs structuraux répétitifs contenant une amine tertiaire ayant un groupe alkylène et un groupe poly(oxyde d'alkylène) lié à un atome de N, et l'éther d'alkyle de polyoxyalkylène étant représenté par la formule (i) $RO-(AO)_n-H$, R étant un groupe $C_{11}$ à $C_{15}$ alkyle ramifié, A étant un groupe alkylène choisi dans le groupe constitué par un groupe éthylène, un groupe propylène et une combinaison correspondante, n représentant des nombres de moles d'addition de AO moyens et étant 2 à 30, un polymère soluble dans l'eau comprenant un polymère contenant un motif structural de poly(alcool vinylique), et
un support aqueux.

**10.** Composition de polissage mécano-chimique selon l'une quelconque des revendications 1 à 9, dans laquelle le substrat est un substrat de silicium.

**11.** Procédé de polissage mécano-chimique d'un substrat, comprenant :

la mise en contact d'un substrat avec un tampon de polissage et la composition de polissage mécano-chimique selon l'une quelconque des revendications 1 à 10,
le déplacement du tampon de polissage par rapport au substrat avec la composition de polissage mécano-chimique entre eux, et
l'abrasion d'au moins une partie du substrat pour polir le substrat.

**12.** Procédé de polissage mécano-chimique d'un substrat selon la revendication 11, dans lequel le procédé comprend, avant l'étape de mise en contact, la dilution de la composition de polissage mécano-chimique et ensuite la filtration de celle-ci avec un filtre ayant un diamètre de pores de 5 μm ou moins.

FIG. 1

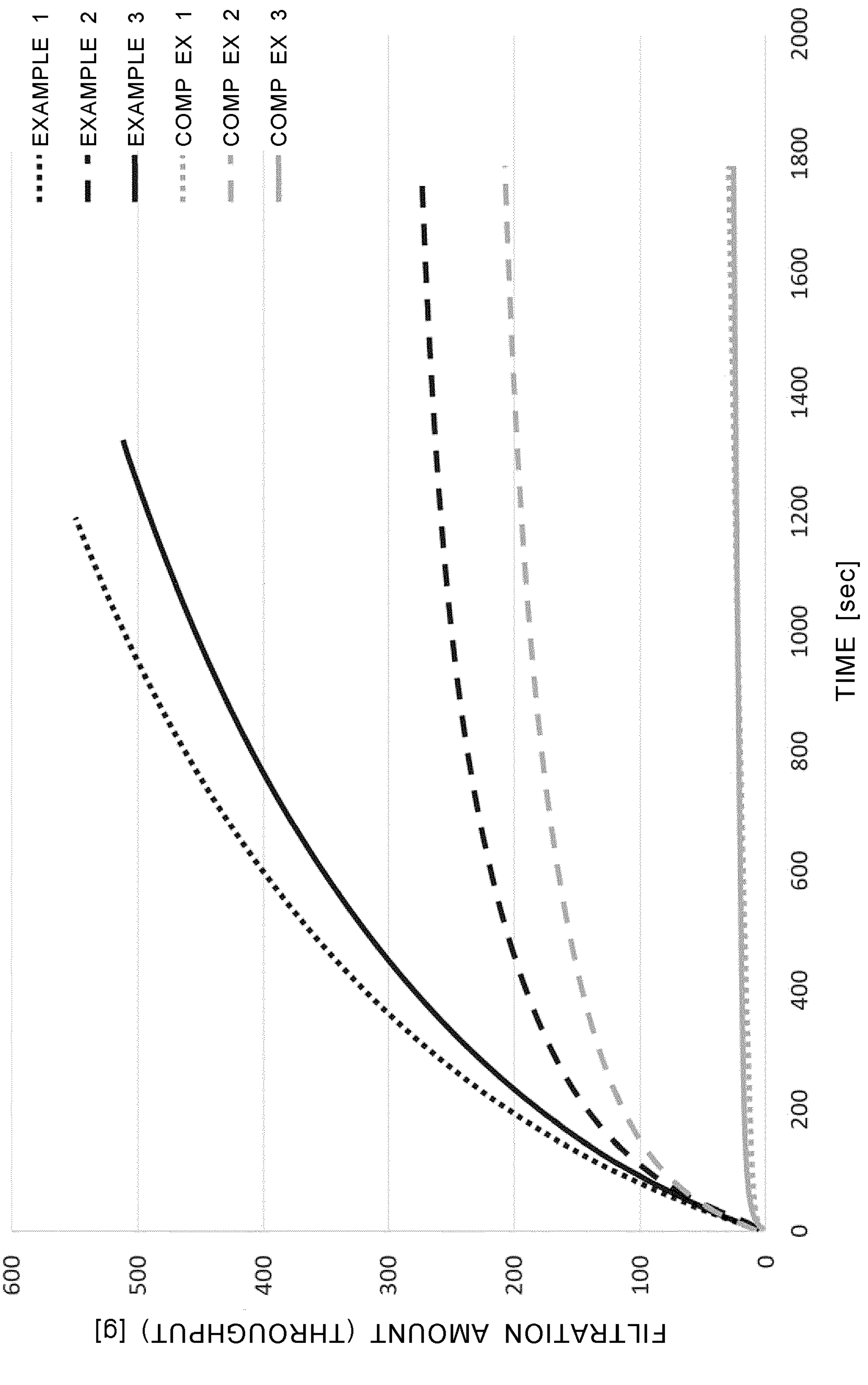
EXAMPLE 1
EXAMPLE 2
EXAMPLE 3
COMP EX 1
COMP EX 2
COMP EX 3
FILTRATION AMOUNT (THROUGHPUT) [g]
TIME [sec]
0
100
200
300
400
500
600
0
200
400
600
800
1000
1200
1400
1600
1800
2000

FIG. 2

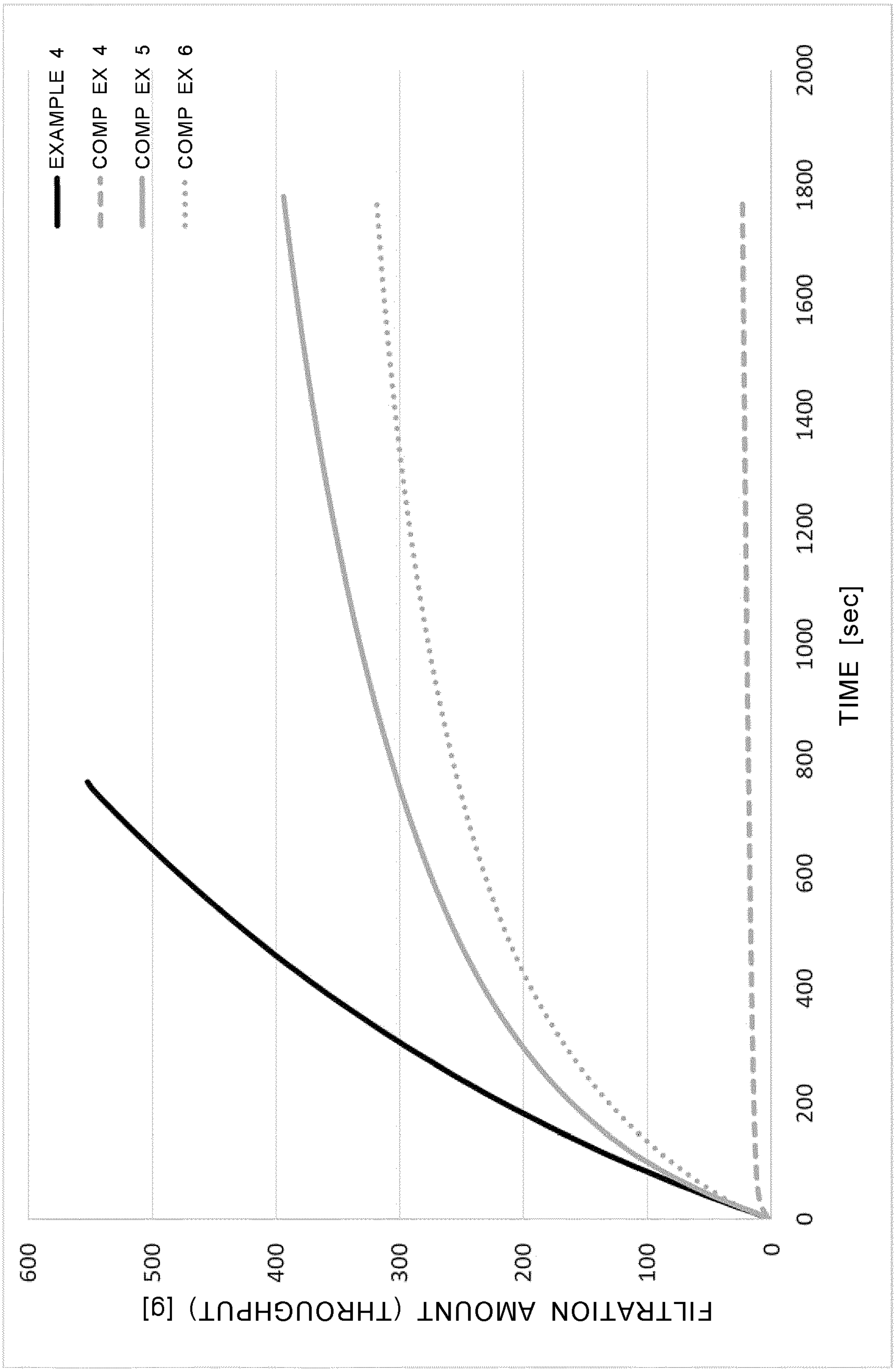
EXAMPLE 4
COMP EX 4
COMP EX 5
COMP EX 6
FILTRATION AMOUNT (THROUGHPUT) [g]
0
100
200
300
400
500
600
TIME [sec]
0
200
400
600
800
1000
1200
1400
1600
1800
2000

FIG. 3

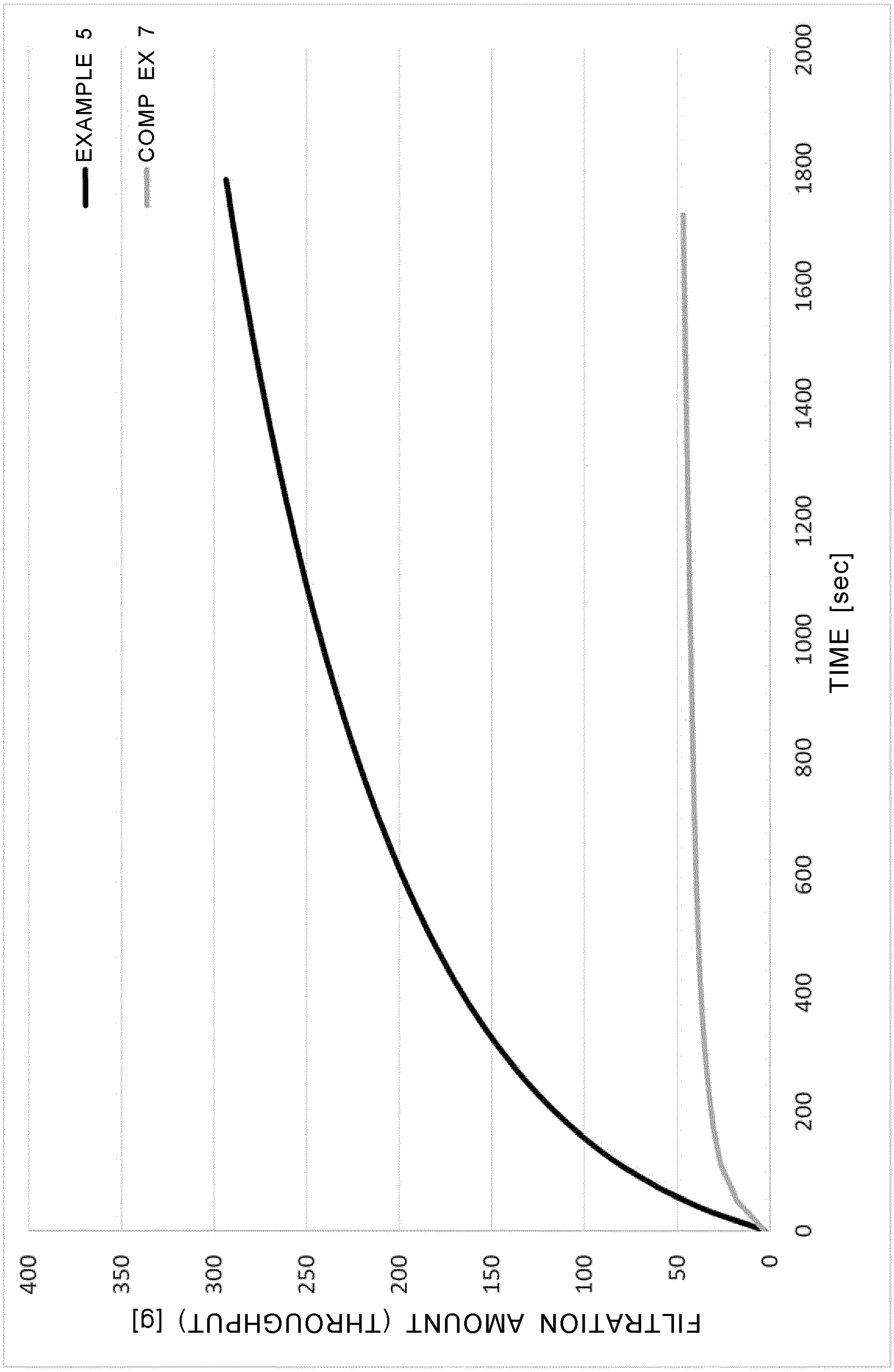
EXAMPLE 5
COMP EX 7
TIME [sec]
FILTRATION AMOUNT (THROUGHPUT) [g]
0
200
400
600
800
1000
1200
1400
1600
1800
2000
0
50
100
150
200
250
300
350
400

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014151424 A
- JP 2015159259 A
- JP 2017117847 A
- JP 2013222863 A


### Non-patent literature cited in the description


- **UEDA et al.** *Research on Paints*, October 2010 (152), 41-46